(19) Europäisches Patentamt

European Patent Office

Office européen des brevets

(11) EP 1 763 081 A2

(12) **EUROPEAN PATENT APPLICATION**

(43) Date of publication:
**14.03.2007 Bulletin 2007/11**

(51) Int Cl.:
***H01L 27/32*** *(2006.01)*

(21) Application number: **06119805.7**

(22) Date of filing: **30.08.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **12.09.2005 JP 2005264126**

(71) Applicant: **Kabushiki Kaisha Toyota Jidoshokki
Kariya-shi,
Aichi 448-8671 (JP)**

(72) Inventor: **Hoshi, Sakutaro
Kariya-shi
Aichi 448-8671 (JP)**

(74) Representative: **TBK-Patent
Bavariaring 4-6
80336 München (DE)**

(54) **Area light emitting device**

(57) Provided is an area light emitting device, including: an EL element which is provided with a structure in which a first electrode layer (2), a thin film layer (3) including a light-emitting layer, and a second electrode layer (4) are stacked on a substrate (1) in a stated order, which has a predetermined area light emitting region, and in which at least one of the first electrode layer (2) and the second electrode layer (4) is a transparent electrode layer; and an auxiliary electrode (7), which is located in the area light emitting region of the EL element, formed of a material having higher conductivity than the transparent electrode layer (2,4), electrically connected with the transparent electrode layer (2,4), and provided with a reflective surface in an outer peripheral portion of the auxiliary electrode (7).

FIG. 1

EP 1 763 081 A2

**Description**

BACKGROUND OF THE INVENTION

Field of the Invention:

The present invention relates to an area light emitting device, and more particularly, to an improvement of light extraction efficiency of an area light emitting device using an electroluminescence (EL) device as a light source.

Description of the Related Art:

An EL device such as an inorganic EL device or an organic EL device performs self-light emission, so a high-luminance surface light source can be obtained. Therefore, the EL device has been widely put into practical use as a display or an area light emitting device used for, for example, a mobile device, which is small in thickness and light in weight. The EL device has, for example, a structure in which a transparent electrode layer which is transparent to light and made of ITO etc. , a thin film layer having a light-emitting layer, and a metal electrode layer which is reflective to light and made of Al etc. are stacked on a transparent substrate made of glass or the like in this order to form an EL element. Light emitted from the light-emitting layer is directly transmitted through the transparent electrode layer or transmitted through the transparent electrode layer after the light is reflected on the metal electrode layer. The light is then transmitted through the transparent substrate and exits from an interface between the transparent substrate and outside air, which serves as a light exit surface.

In the case that a refractive index of a substance located on a light incident side is larger than a refractive index of a substance located on a light exit side at each of an interface between the thin film layer and the transparent electrode layer, an interface surface between the transparent electrode layer and the transparent substrate, and the interface between the transparent substrate and outside air, light whose incident angle exceeds a critical angle determined based on a ratio between a refractive index of glass or the like which is a material of the transparent substrate and a refractive index of air is totally reflected on, for example, the interface between the transparent substrate serving as the light exit surface and outside air. Therefore, the light cannot be extracted.

In order to solve such a problem, in the case of a display device described in JP 10-189251 A, a reflecting member having a wedge shape in section is provided in the transparent substrate so as to surround an outer peripheral portion of each of pixels. Light emitted from the light-emitting layer in each of the pixels is reflected on the reflecting member located in the outer peripheral portion thereof to change an angle of the light. Therefore, the amount of light totally reflected on the interface surface between the transparent substrate and outside air is reduced, thereby improving light extraction efficiency.

However, the reflectingmember for the display device described in JP 10-189251 A is formed in a position opposing to a gap between the respective pixels separated from one another and arranged in matrix. Therefore, it is difficult that the display device is applied to an area light emitting device in which an EL element is formed on the entire surface of a transparent substrate without any modifications.

Electrical resistivity of the transparent electrode layer is approximately several hundreds $\mu\Omega$ cm in the case of, for example, ITO. Therefore, the electrical resistivity of the transparent electrode layer is larger than electrical resistivity of the metal electrode layer, which is, for example, 2.65 $\mu\Omega$ cm in the case of Al or 1.59 $\mu\Omega$ cm in the case of Ag by approximately two digits. As a result, in the area light emitting device in which the EL element is formed on the entire surface of the transparent substrate, voltage drop of the transparent electrode layer in the in-plane direction thereof cannot be neglected, so it is likely to cause luminance unevenness at the time of light emission. In general, a terminal of the transparent electrode layer is formed in a non-light-emitting region. Therefore, as a size of a light-emitting surface increases, the difference in a voltage drop between a light-emitting region located at a long distance from the terminal and another light-emitting region located at a short distance from the terminal becomes larger. As a result, a luminance unevenness is generated.

In order to reduce the luminance unevenness caused by the voltage drop of the transparent electrode layer as described above, there has been proposed a method of forming an auxiliary electrode made of a material having excellent conductivity, such as metal, in the non-light-emitting region so as to be connected with the transparent electrode layer. However, even in the case where the auxiliary electrode is used, when the size of the light-emitting surface increases, the difference in a voltage drop between a light-emitting region located at a long distance from the terminal and another light-emitting region located at a short distance from the terminal becomes larger. Therefore, it is difficult to resolve a problem of the luminance unevenness.

Note that, when the transparent electrode layer is thickened, the voltage drop in the in-plane direction can be suppressed. However, the transmittance of the transparent electrode layer is reduced corresponding to an increase in thickness thereof, so that a problem occurs in that light-emitting efficiency of the EL element reduces.

## SUMMARY OF THE INVENTION

The present invention has been made to resolve the above-mentioned conventional problems. An object of the present invention is to provide an area light emitting device capable of improving light extraction efficiency and reducing luminance unevenness caused by voltage drop of a transparent electrode layer.

An area light emitting device according to the present invention, comprises: an EL element comprising: a first electrode layer; a thin film layer including a light-emitting layer; and a second electrode layer stacked on a substrate in the stated order, the EL element having a predetermined area light emitting region, at least one of the first electrode layer and the second electrode layer being a transparent electrode layer; and an auxiliary electrode located in the area light emitting region of the EL element, and formed of a material having higher conductivity than the transparent electrode layer, the auxiliary electrode being electrically connected with the transparent electrode layer, the auxiliary electrode having a reflective surface in an outer peripheral portion thereof.

## BRIEF DESCRIPTION OF THE DRAWINGS

FIG. 1 is a cross sectional view showing a structure of an area light emitting device according to a first embodiment of the present invention;
FIG. 2 is a plan view showing the area light emitting device according to the first embodiment;
FIGS. 3A to 3D are views showing, in a stepwise manner, a method of producing an auxiliary electrode used for the area light emitting device according to the first embodiment;
FIG. 4 is a cross sectional view showing a structure of an area light emitting device according to a second embodiment;
FIGS. 5A to 5D are views showing, in a stepwise manner, a method of producing an auxiliary electrode used for the area light emitting device according to the second embodiment;
FIG. 6 is a cross sectional view showing an auxiliary electrode used for an area light emitting device according to a third embodiment;
FIG. 7 is a cross sectional view showing an auxiliary electrode used for an area light emitting device according to a fourth embodiment;
FIG. 8 is a cross sectional view showing an auxiliary electrode used for the area light emitting device according to a modified example of the fourth embodiment;
FIG. 9 is a cross sectional view showing an auxiliary electrode used for an area light emitting device according to a fifth embodiment;
FIG. 10 is a cross sectional view showing an auxiliary electrode used for the area light emitting device according to a modified example of the fifth embodiment;
FIG. 11 is a cross sectional view showing a structure of an area light emitting device according to another embodiment; and
FIG. 12 is a cross sectional view showing a structure of an area light emitting device according to yet another embodiment.

## DETAILED DESCRIPTION OF THE PREFERRED EMBODIMENTS

Embodiments of the present invention will be described hereinafter with reference to the accompanying drawings. Note that each of the drawings shows a schematic structure, and thus a size ratio, a thickness ratio, or the like is different from an actual ratio.

First embodiment

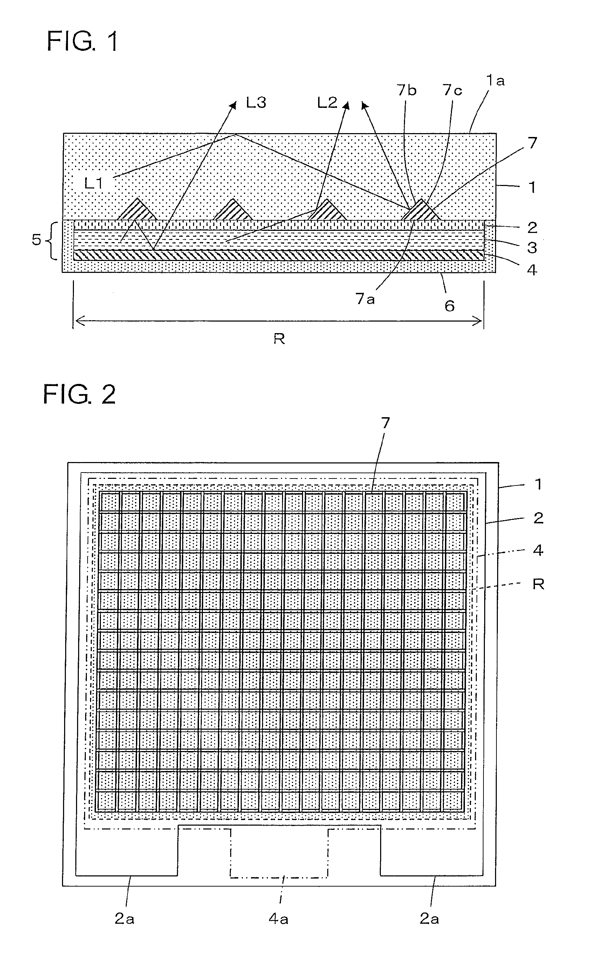

FIG. 1 shows a cross sectional structure of an area light emitting device according to a first embodiment. A transparent electrode layer 2 serving as a first electrode layer is formed on a surface of a transparent substrate 1 serving as a substrate. An organic layer 3 made of an organic compound and serving as a thin film layer including a light-emitting layer is formed on the transparent electrode layer 2. A metal electrode layer 4 serving as a second electrode layer is formed on the organic layer 3. An organic electroluminescence (EL) element 5 having a predetermined area light emitting region R is formed by the transparent electrode layer 2, the organic layer 3, and the metal electrode layer 4. The entire organic EL element 5 is covered with a protective film 6. A surface 1a of the transparent substrate 1 opposite to the transparent electrode layer 2 serves as an exit surface of the area light emitting device.

An auxiliary electrode 7 is formed on an interface between the transparent substrate 1 and the transparent electrode layer 2. The auxiliary electrode 7 is made of a material having conductivity superior to the transparent electrode layer 2 and has a cross sectional shape of a right isosceles triangle. In addition, the auxiliary electrode 7 is buried in the transparent substrate 1 such that an outer peripheral surface 7a to become a bottom surface is in contact with a surface of the transparent electrode layer 2 and each of two outer peripheral surfaces 7b and 7C which intersect with each other at right angle is opposed to the surface 1a of the transparent substrate 1. Because of the contact between the outer peripheral surface 7a and the surface of the transparent electrode layer 2, the auxiliary electrode 7 is electrically connected with the transparent electrode layer 2. The three outer peripheral surfaces 7a, 7b, and 7c of the auxiliary electrode 7 form reflective surfaces for reflecting at least visible light.

As shown in FIG. 2, the auxiliary electrode 7 is arranged in a grid shape in the area light emitting region R of the organic EL element 5.

The transparent electrode layer 2 and the metal electrode layer 4 have terminal portions 2a and 4a, respectively, which extend to the outside of the area light emitting region R.

The transparent substrate 1 may be made of a material transparent to visible light, and glass, resin, or the like can be used. The transparent electrode layer 2 may serve as an electrode and be transparent to at least visible light. For example, ITO is used as a material of the transparent electrode layer 2.

The organic layer 3 may be a single layer of only the light-emitting layer or a multilayer in which the light-emitting layer and at least one selected from the group including a hole injection layer, a hole transport layer, a hole injection and transport layer, a hole blocking layer, an electron injection layer, an electron transport layer, and an electron blocking layer are stacked. The light-emitting layer contains at least a known organic light-emitting material such as $Alq_3$ or DCM. Each of the hole injection layer, the hole transport layer, the hole injection and transport layer, the hole blocking layer, the electron injection layer, the electron transport layer, the electron blocking layer, and the like is made of a known material as appropriate.

The metal electrode layer 4 may serve as an electrode and be reflective to at least visible light. For example, Al, Cr, Mo, an Al alloy, an Al/Mo stacked material, or the like can be used.

A silicon nitride, a silicon oxynitride, a silicon oxide, or the like which is formed using, for example, a plasma CVD method is used for the protective film 6.

The auxiliary electrode 7 is made of a material having excellent conductivity and excellent reflectivity for at least visible light, such as Ag or Al. The outer peripheral surface 7a of the auxiliary electrode 7 is formed with a width of 50 $\mu$m and an arrangement pitch of 200 $\mu$m.

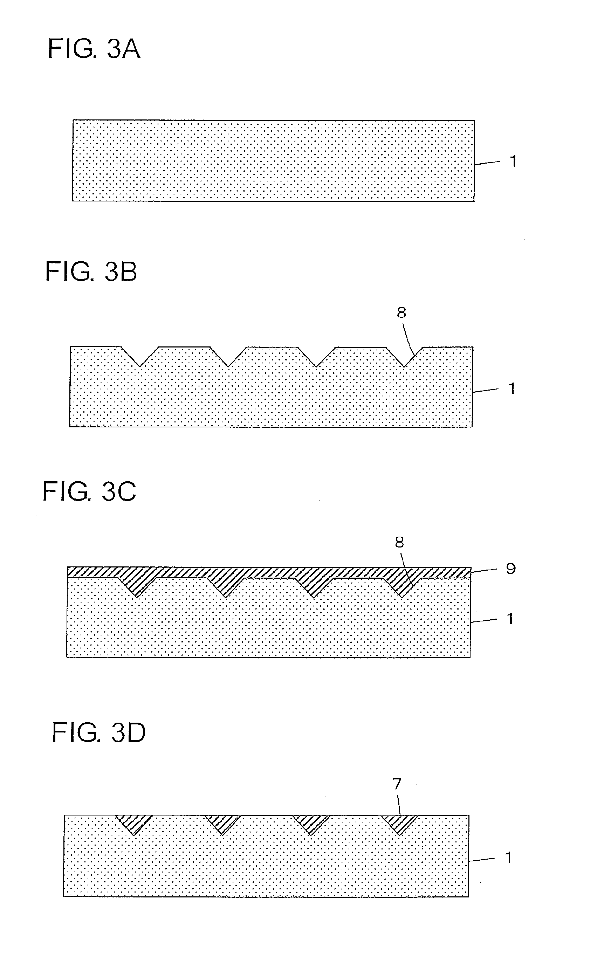

Here, a method of producing the auxiliary electrode 7 will be described with reference to FIG. 3. First, the surface of the transparent substrate 1 shown in FIG . 3A is subjected to cut processing to form grooves 8 arranged in a grid shape, each of which has a cross sectional shape of a right isosceles triangle as shown in FIG. 3B. In addition to mechanical processing, laser processing, chemical processing, or the like can also be used to form the grooves 8. Next, as shown in FIG. 3C, for example, Ag is vapor-deposited on the surface of the transparent substrate 1 until an inner portion of each of the grooves 8 is filled therewith, thereby forming an Ag layer 9. The Ag layer 9 is then etched to expose the surface of the transparent substrate 1. Therefore, as shown in FIG. 3D, the auxiliary electrode 7 buried in the surface of the transparent substrate 1 are produced.

After that, it is only necessary that the transparent electrode layer 2, the organic layer 3, and the metal electrode layer 4 be stacked in this order on the surface of the transparent substrate 1 in which the auxiliary electrode 7 is buried, to form the organic EL element 5.

Next, an operation of the area light emitting device according to the first embodiment will be described. A power source circuit which is not shown is connected between the terminal potions 2a and 4a and a current is allowed to flow between the transparent electrode layer 2 and the metal electrode layer 4 to turn on the organic EL element 5. That is, light emitted from the light-emitting layer of the organic layer 3 is directly incident on the transparent electrode layer 2 or incident on the transparent electrode layer 2 after the light is reflected on the metal electrode layer 4, and then exits from the surface 1a through the transparent substrate 1.

In general, a refractive index of glass or the like which is a material of the transparent substrate 1 is larger than a refractive index of air. Therefore, as shown in FIG. 1, a light beam L1 which is transmitted through the transparent substrate 1 and then is incident on the surface 1a serving as the light exit surface at an incident angle exceeding a critical angle is totally reflected on the surface 1a and travels through the transparent substrate 1 again. Here, because the auxiliary electrode 7, which has the cross sectional shape of the right isosceles triangle, is arranged in an interface surface between the transparent substrate 1 and the transparent electrode layer 2, when the light beam L1 is reflected on the outer peripheral surface 7b or 7c of the auxiliary electrode 7, the optical path of the light beam L1 is adjusted. The light beam L1 is thus incident on the surface 1a at an incident angle smaller than the critical angle and then exits from the surface 1a to outside air.

When, among light beams emitted from the light-emitting layer of the organic layer 3, a light beam L2 incident on the transparent substrate 1 at a large incident angle from the transparent electrode layer 2 is reflected on the outer peripheral surface 7b or 7c of the auxiliary electrode 7, the optical path of the light beam L2 is adjusted. Therefore, the light beam L2 is incident on the surface 1a at an incident angle smaller than the critical angle and then exits from the surface 1a to outside air.

As described above, because of the presence of the auxiliary electrode 7, light confined in a conventional area light emitting device can be extracted to air, thereby improving the light extraction efficiency.

Because of the presence of light beams, each of which is reflected on the outer peripheral surface 7b or 7c of the auxiliary electrode 7 and then exits from the surface 1a of the transparent substrate 1 to outside air, such as the above-mentioned light beams L1 and L2, when the area light emitting device is viewed from the surface 1a side of the transparent substrate 1, it is hard to view the auxiliary electrode 7. Therefore, a uniform light-emitting surface is obtained.

When a light beam emitted from the light-emitting layer of the organic layer 3 is reflected on the outer peripheral surface 7a of the auxiliary electrode 7 which is in contact with the transparent electrode layer 2, the light beam cannot enter the transparent substrate 1 and is returned to the organic EL element 5 again. However, when an incident angle is not 0 relative to the outer peripheral surface 7a of the auxiliary electrode 7, as in the case of a light beam L3 shown in FIG. 1, a light beam is reflected on the metal electrode layer 4 of the organic EL element 5 or repeatedly reflected between the outer peripheral surface 7a of the auxiliary electrode 7 and the metal electrode layer 4. After that, the light beam is incident on the transparent substrate 1 from a region in which the auxiliary electrode 7 is not located and the light beam exits from the surface 1a to outside air. Therefore, a reduction in light extraction efficiency which is caused by blocking by the auxiliary electrode 7 is minimized.

The auxiliary electrode 7, which is made of the material having conductivity superior to the transparent electrode layer 2, is arranged in the grid shape in the area light emitting region R of the organic EL element 5 and electrically connected with the transparent electrode layer 2. Therefore, a part of the auxiliary electrode 7 is located close to each point in the area light emitting region R, so that the luminance unevenness caused by the voltage drop of the transparent electrode layer 2 in the in-plane direction thereof is reduced. Across sectional area of the auxiliary electrode 7, a width of the outer peripheral surface 7a in contact with the transparent electrode layer 2, an arrangement pitch of the auxiliary electrode 7, and the like are preferably selected so as to minimize the luminance unevenness.

The auxiliary electrode 7 is arranged in the area light emitting region R of the organic EL element 5, so it is unnecessary to form the auxiliary electrode in a non-light-emitting region, unlike a conventional case. Therefore, although a size of the area light emitting region R is equal to that in the conventional case, a small area light emitting device can be realized. Thus, when a plurality of area light emitting devices are to be cut out from a parent substrate, more area light emitting devices can be cut out from the same parent substrate, so that it is possible to reduce a manufacturing cost of the area light emitting device.

Second embodiment

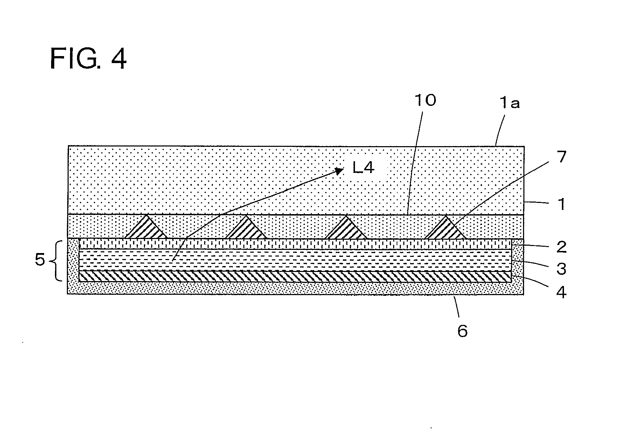

FIG.4 shows a cross sectional structure of an area light emitting device according to a second embodiment. This area light emitting device is different from the area light emitting device according to the first embodiment as shown in FIG. 1 in the point that a refractive index adjusting layer 10 is formed between the transparent substrate 1 and the transparent electrode layer 2 of the organic EL element 5 and the auxiliary electrode 7 is formed in the refractive index adjusting layer 10. The auxiliary electrode 7 is electrically connected with the transparent electrode layer 2 through the contact with the surface of the transparent electrode layer 2.

The refractive index adjusting layer 10 is transparent to at least visible light and made of a material having an intermediate value between a refractive index of the transparent substrate 1 and a refractive index of the transparent electrode layer 2.

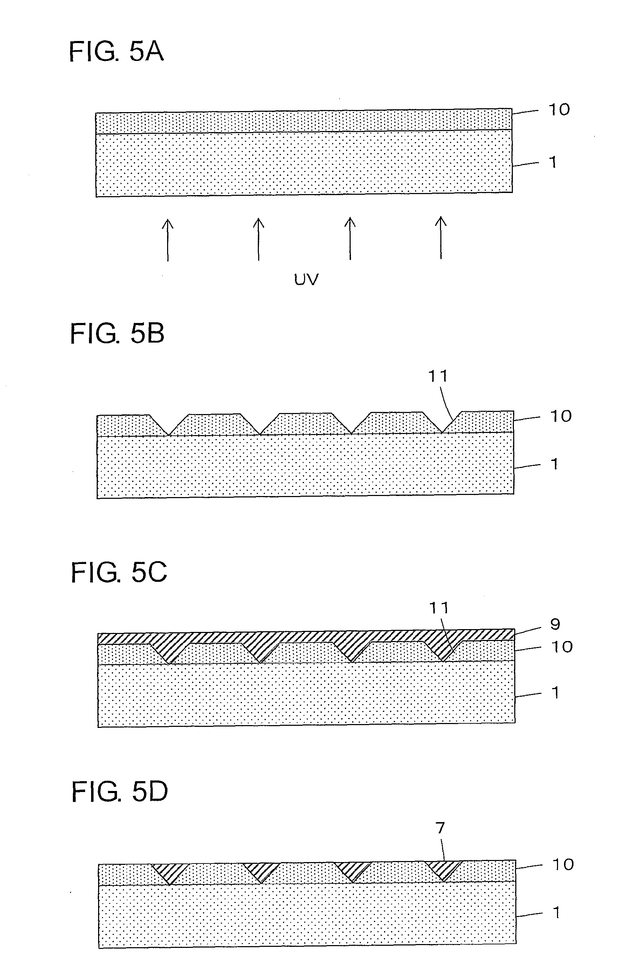

A method of manufacturing an area light emitting device 7 including the refractive index adjusting layer 10 will be described. First, as shown in FIG. 5A, the refractive index adjusting layer 10 made of, for example, a negative photopolymer is formed on the surface of the transparent substrate 1, and then ultraviolet (UV) light in a grid shape corresponding to an arrangement shape of the auxiliary electrode 7 to be formed is emitted from the rear surface side of the transparent substrate 1 to the refractive index adjusting layer 10 through the transparent substrate 1. After that, the refractive index adjusting layer 10 is developed, so that, as shown in FIG. 5B, grid-shaped grooves 11, each of which has a cross sectional shape of a triangle, are formed in the refractive index adjusting layer 10 based on a development rate difference caused by an exposure amount difference in a thickness direction. Next, as shown in FIG. 5C, for example, Ag is vapor-deposited on the surface of the refractive index adjusting layer 10 until an inner portion of each of the grooves 11 is filled therewith, thereby forming an Ag layer 9. The Ag layer 9 is then etched to expose the surface of the refractive index adjusting layer 10. Therefore, as shown in FIG. 5D, the auxiliary electrode 7 buried in the surface of the refractive index adjusting layer 10 is produced.

After that, it is only necessary that the transparent electrode layer 2, the organic layer 3, and the metal electrode layer 4 be stacked in this order on the surface of the refractive index adjusting layer 10 in which the auxiliary electrode 7 is buried, to form the organic EL element 5.

It is preferable that the photopolymer used for forming the refractive index adjusting layer 10 be a material in which the amount of outgassing after molding is small.

Next, an operation of the area light emitting device according to the second embodiment will be described. A current is allowed to flow between the transparent electrode layer 2 and the metal electrode layer 4 to turn on the organic EL element 5. At this time, light emitted from the light-emitting layer of the organic layer 3 is directly incident on the transparent electrode layer 2 or incident on the transparent electrode layer 2 after the light is reflected on the metal electrode layer 4, and then exits from the surface 1a through the refractive index adjusting layer 10 and the transparent substrate 1.

Assume that a refractive index of glass or the like which is a material of the transparent substrate 1 is expressed by n1, a refractive index of ITO or the like which is a material of the transparent electrode layer 2 is expressed by n2, and a refractive index of the refractive index adjusting layer 10 is expressed by n3. In general, n1 < n2 is established and the refractive index of the refractive index adjusting layer 10 is an intermediate value between n1 and n2. Therefore, the following expression is obtained.

$$n1 \; < \; n3 \; < \; n2 \qquad (1)$$

Here, in the case of a structure in which the transparent substrate 1 and the transparent electrode layer 2 are in direct contact with each other as in the area light emitting device according to the first embodiment, a critical angle θ determined for light traveling from the transparent electrode layer 2 to the transparent substrate 1 is expressed by

$$\sin \; \theta \; = \; n1 \; / \; n2 \qquad (2).$$

In contrast to this, in the case of a structure in which the refractive index adjusting layer 10 is interposed between the transparent electrode layer 2 and the transparent substrate 1 as in the area light emitting device according to the second embodiment, a critical angle α determined for light traveling from the transparent electrode layer 2 to the refractive index adjusting layer 10 is expressed by

$$\sin \; \alpha \; = \; n3 \; / \; n2 \qquad (3)$$

and a critical angle β determined for light traveling from the refractive index adjusting layer 10 to the transparent substrate 1 is expressed by

$$\sin \; \beta \; = \; n1 \; / \; n3 \qquad (4).$$

When the expressions (3) and (4) are rewritten using the expressions (1) and (2), the following expressions

$$\sin \; \alpha \; = \; (n3 \; / \; n2) \; > \; (n1 \; / \; n2) \; = \; \sin \; \theta \qquad (5)$$

$$\sin \; \beta \; = \; (n1 \; / \; n3) \; > \; (n1 \; / \; n2) \; = \; \sin \; \theta \qquad (6)$$

are obtained. Therefore, the following expressions

$$\alpha \; > \; \theta$$

$$\beta \; > \; \theta$$

are derived from the expressions (5) and (6).

That is, as is apparent from the second embodiment, each of the critical angle $\alpha$ for light traveling from the transparent electrode layer 2 to the refractive index adjusting layer 10 and the critical angle $\beta$ for light traveling from the refractive index adjusting layer 10 to the transparent substrate 1 becomes larger than the critical angle $\theta$ for light traveling from the transparent electrode layer 2 to the transparent substrate 1 in the structure in which the transparent substrate 1 and the transparent electrode layer 2 are in direct contact with each other as in the first embodiment, so that the amount of totally reflected light reduces. Therefore, the amount of light beam transmitted through the transparent substrate 1 without total reflection on an interface surface between the transparent electrode layer 2 and the refractive index adjusting layer 10 and an interface surface between the refractive index adjusting layer 10 and the transparent substrate 1 increases as in the case of a light beam L4 shown in FIG. 4, thereby further improving the light extraction efficiency as compared with the case of the area light emitting device according to the first embodiment.

Note that a light extraction effect caused by reflection on the outer peripheral surfaces 7a to 7c of the auxiliary electrode 7 and a luminance unevenness reducing effect caused by the presence of the auxiliary electrode 7 are identical to those in the first embodiment.

Third embodiment

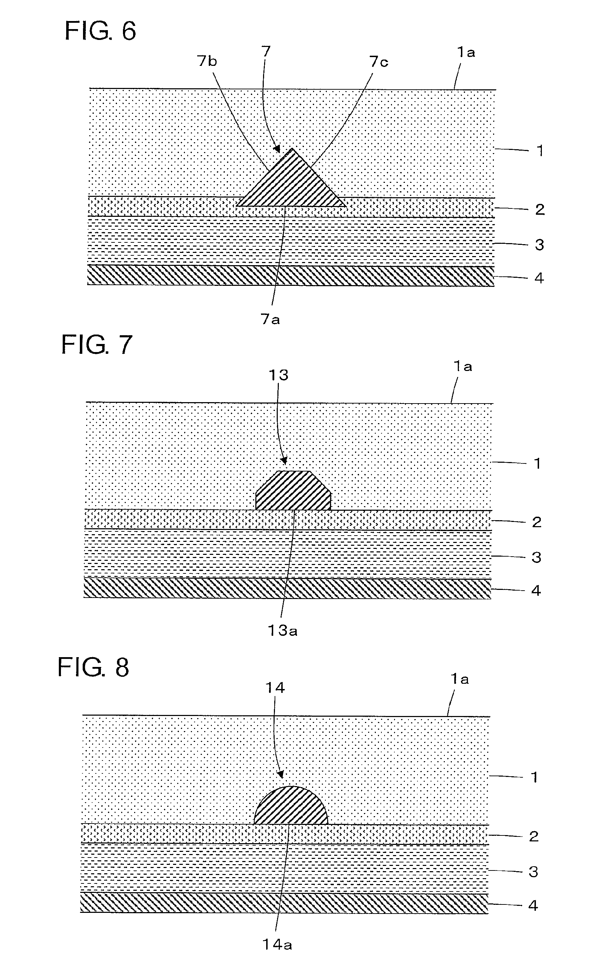

FIG. 6 shows an auxiliary electrode 7 for an area light emitting device according to a third embodiment. In the area light emitting device according to the first embodiment described above, the auxiliary electrode 7 is buried in the transparent substrate 1 so as to be in contact with the surface of the transparent electrode layer 2. In the third embodiment, the auxiliary electrode 7 is buried in the inner portion of the transparent electrode layer 2 and the inner portion of the transparent substrate 1. The outer peripheral surfaces 7a to 7c of the auxiliary electrode 7 are in contact with the transparent electrode layer 2, so that the auxiliary electrode 7 is electrically connected with the transparent electrode layer 2. The auxiliary electrode 7 is buried in the transparent substrate 1 such that the outer peripheral surface 7a to become the bottom surface thereof is not in contact with the surface of the organic layer 3.

Even when the auxiliary electrode 7 is used, as in the case of the first embodiment, the light extraction efficiency is improved by light reflection on the outer peripheral surfaces 7a to 7c of the auxiliary electrode 7 and the luminance unevenness caused by the voltage drop of the transparent electrode layer 2 in the in-plane direction thereof is reduced.

The auxiliary electrode 7 according to the third embodiment can be applied to the second embodiment to bury the auxiliary electrode 7 in the inner portion of the transparent electrode layer 2 and the inner portion of the refractive index adjusting layer 10.

Fourth embodiment

FIGS. 7 and 8 each shows an auxiliary electrode 13, 14 for an area light emitting device according to a fourth embodiment. In the area light emitting device according to each of the first to third embodiments described above, the auxiliary electrode 7 has the cross sectional shape of the right isosceles triangle. In contrast to this, as shown in FIG. 7, an auxiliary electrode 13 having a cross sectional shape of a polygon such as a hexagon is used. The auxiliary electrode 13 is made of a material having conductivity superior to the transparent electrode layer 2 and buried in the transparent substrate 1 such that an outer peripheral surface 13a to become a bottom surface is in contact with the surface of the transparent electrode layer 2. Each of outer peripheral surfaces including the bottom surface of the auxiliary electrode 13 forms a reflective surface for reflecting at least visible light.

The auxiliary electrode 13 has more reflective surfaces set to various angles as compared with the auxiliary electrode 7 having the cross sectional shape of the right isosceles triangle used in each of the first to third embodiments. Therefore, a traveling direction of light confined in a conventional area light emitting device can be adjusted to various directions, so that the light extraction efficiency can be improved.

A cross sectional shape of the auxiliary electrode is not limited to the right isosceles triangle and the hexagon and thus it is possible to use an auxiliary electrode having a cross sectional shape of an arbitrary polygon.

As shown in FIG. 8, an auxiliary electrode 14 having a cross sectional shape of an arc can be also used. An outer peripheral surface 14a to become a bottom surface is in contact with the surface of the transparent electrode layer 2.

The auxiliary electrode 13 or 14 according to the fourth embodiment may be applied to the second embodiment to bury the auxiliary electrode 13 or 14 in the refractive index adjusting layer 10. The auxiliary electrode 13 or 14 can be also applied to the third embodiment to bury the auxiliary electrode 13 or 14 in the inner portion of the transparent electrode layer 2 and the inner portion of the transparent substrate 1, or the inner portion of the transparent electrode layer 2 and the inner portion of the refractive index adjusting layer 10.

Fifth embodiment

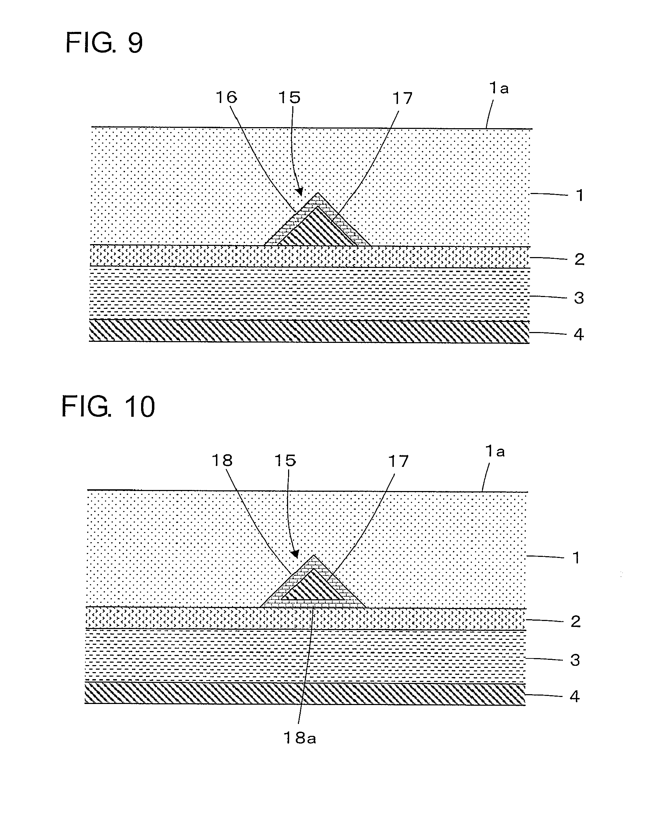

FIGS. 9 and 10 each shows an auxiliary electrode 15 for an area light emitting device according to a fifth embodiment. In the area light emitting devices according to the first to fourth embodiments described above, each of the auxiliary electrodes 7, 13, and 14 is made of a single material. In contrast to this, an auxiliary electrode 15 made of two kinds of materials and having a two-layer structure is used in the fifth embodiment. As shown in FIG. 9, the auxiliary electrode 15 includes: an outer peripheral portion 16 which is opposed to the surface 1a of the transparent substrate 1 to become the exit surface of the area light emitting device and made of a first material having excellent reflectivity; and an inner portion 17 which is located inside the outer peripheral portion 16 in contact with the transparent electrode layer 2 and made of a second material having excellent reflectivity. For example, the outer peripheral portion 16 can be made of Al as the first material and the inner portion 17 can be made of Cu as the second material.

When the auxiliary electrode 15 having such a structure is used, the light reflection efficiency of the outer peripheral portion 16 is high and the conductivity of the inner portion 17 connected with the transparent electrode layer 2 is high, so it is possible to simultaneously realize a further improvement of the light extraction efficiency and a further reduction in luminance unevenness caused by the voltage drop of the transparent electrode layer 2 in the in-plane direction thereof.

In addition, as shown in FIG. 10, the auxiliary electrode 15 can include an outer peripheral portion 18 forming all outer peripheral surfaces of the auxiliary electrode 15 and is made of the first material having excellent reflectivity. For example, the outer peripheral portion 18 can be made of Al as the first material and the inner portion 17 can be made of Cu as the second material.

When the auxiliary electrode 15 having such a structure is used, the reflectivity of an outer peripheral surface 18a, which becomes a bottom surface of the auxiliary electrode 15 is improved.

In each of the first to fifth embodiments described above, the auxiliary electrode is arranged in the grid shape in the area light emitting region R of the organic EL element 5. However, the present invention is not limited to this arrangement. For example, a parallel-shaped arrangement can be employed. The auxiliary electrode is not necessarily provided with the same size and the same cross sectional shape in the area light emitting region R of the organic EL element 5 and thus may have different sizes and different cross sectional shapes.

In the method of producing the auxiliary electrode 7 as shown in FIGS. 3 and 5, the Ag layer 9 is formed by vapor deposition. In addition to this, the Ag layer 9 can be formed by plating, sputtering, or the like.

The thickened Ag layer 9 is etched to expose the surface of the transparent substrate 1 or the surface of the refractive index adjusting layer 10. However, by filling the grooves 8 of the transparent substrate 1 or the grooves 11 of the refractive index adjusting layer 10 with the material, such as Ag, for forming the auxiliary electrode 7 by using a mask or a resist film having openings corresponding to the grooves 8 or 11 and then removing the mask or the resist film, the auxiliary electrode 7 can also be produced.

A luminance distribution on the area light emitting region R of the organic EL element 5 is changed by selecting a cross sectional area of the auxiliary electrode, an arrangement pitch thereof, and the like, so not only the luminance unevenness can be reduced but also a desirable luminance shape can be formed on the area light emitting region R to show a presentation effect.

According to the present invention, the light extraction efficiency can be improved, so an area light emitting device is realized with longer life, higher luminance, and lower power consumption.

The material with reflectivity to visible light is used for the metal electrode layer 4, which is the second electrode layer. A material without reflectivity but with the same function as an electrode can be used for the second electrode layer.

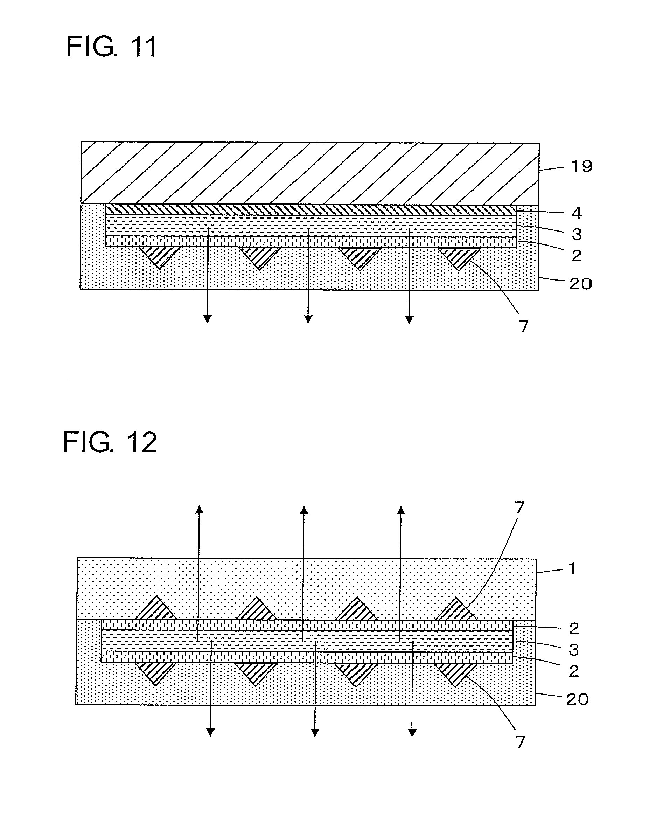

In each of the embodiments described above, the structure in which light exits from the transparent substrate side is used. However, the present invention is not limited to the structure. For example, it is also possible to use a structure in which light exits from the opposite side to the substrate. In this case, as shown in FIG. 11, the metal electrode layer 4 serving as the first electrode layer, the organic layer 3 serving as the thin film layer including the light-emitting layer, and the transparent electrode layer 2 serving as the second electrode layer are stacked in this order on a substrate 19. Then, a protective layer 20 transparent to light, for protecting the thin film layer from moisture, oxygen, and the like in outside air is provided on the transparent electrode layer 2. The auxiliary electrode 7 is formed in the protective film 20 so as to electrically connect with the transparent electrode layer 2. In this case, the substrate 19 is not necessarily transparent to light and thus can be made of, for example, metal.

As shown in FIG. 12, in the case of the area light emitting device shown in FIG. 11, the transparent substrate 1 may be used instead of the substrate 19 and the transparent electrode layer 2 instead of the metal electrode layer 4 as the first electrode layer to obtain a structure in which light exits from both sides, that is, the transparent substrate 1 side and the opposite side to the transparent substrate 1. In this case, the auxiliary electrode 7 is provided in each of the transparent substrate 1 and the protective film 20.

In each of the embodiments described above, the area light emitting device including the organic EL element is described. However, the present invention is not limited to this and thus applied to an area light emitting device as well including an inorganic EL element in which the thin film layer having the light-emitting layer interposed between the transparent electrode layer and the reflection electrode layer is made of an inorganic compound.

Provided is an area light emitting device, including: an EL element which is provided with a structure in which a first electrode layer, a thin film layer including a light-emitting layer, and a second electrode layer are stacked on a substrate in a stated order, which has a predetermined area light emitting region, and in which at least one of the first electrode layer and the second electrode layer is a transparent electrode layer; and an auxiliary electrode, which is located in the area light emitting region of the EL element, formed of a material having higher conductivity than the transparent electrode layer, electrically connected with the transparent electrode layer, and provided with a reflective surface in an outer peripheral portion of the auxiliary electrode.

**Claims**

1. An area light emitting device, comprising:

    an EL element comprising: a first electrode layer; a thin film layer including a light-emitting layer; and a second electrode layer stacked on a substrate in the stated order, the EL element having a predetermined area light emitting region, at least one of the first electrode layer and the second electrode layer being a transparent electrode layer; and
    an auxiliary electrode located in the area light emitting region of the EL element, and formed of a material having higher conductivity than the transparent electrode layer, the auxiliary electrode being electrically connected with the transparent electrode layer, the auxiliary electrode having a reflective surface in an outer peripheral portion thereof.

2. An area light emitting device according to claim 1, wherein the substrate comprises a transparent substrate, the first electrode layer being the transparent electrode layer, light exiting from a side of the transparent substrate.

3. An area light emitting device according to claim 2, wherein the auxiliary electrode is buried in the transparent substrate.

4. An area light emitting device according to claim 2, wherein the second electrode layer is a metal electrode layer having reflectivity.

5. An area light emitting device according to claim 2, further comprising: a refractive index adjusting layer which is located between the transparent substrate and the transparent electrode layer and has a refractive index which is an intermediate value between a refractive index of the transparent substrate and a refractive index of the transparent electrode layer,
    the auxiliary electrode being buried in the refractive index adjusting layer.

6. An area light emitting device according to claim 1, further comprising: a protective film which is transparent to light and formed on the second electrode layer,
    the second electrode layer being the transparent electrode layer, light exiting from a side of the protective film.

7. An area light emitting device according to claim 6, wherein the auxiliary electrode is buried in the protective film.

8. An area light emitting device according to claim 6, wherein the first electrode layer is a metal electrode layer having reflectivity.

9. An area light emitting device according to claim 6, wherein the substrate comprises a metal substrate.

10. An area light emitting device according to claim 1, further comprising: a protective film which is transparent to light and formed on the second electrode layer,
    the substrate comprising a transparent substrate, each of the first electrode layer and the second electrode layer being the transparent electrode layer, light exiting from both a side of the transparent substrate and a side of the protective film.

11. An area light emitting device according to claim 10, wherein the auxiliary electrode is buried in each of the transparent substrate and the protective film.

12. An area light emitting device according to claim 1, wherein the auxiliary electrode is arranged in a grid shape in the area light emitting region of the EL element.

13. An area light emitting device according to claim 1, wherein a portion of the auxiliary electrode is buried in the transparent electrode layer.

14. An area light emitting device according to claim 1, wherein the auxiliary electrode has a cross sectional shape of a polygon.

15. An area light emitting device according to claim 1, wherein the auxiliary electrode has a cross sectional shape of an arc.

16. An area light emitting device according to claim 1, wherein the auxiliary electrode comprises an outer peripheral portion in which at least a part of the auxiliary electrode contains a first material having excellent reflectivity and an inner portion which contains a second material having excellent conductivity.

17. An area light emitting device according to claim 1, wherein the thin film layer is formed of an organic compound.

FIG. 1

FIG. 2

FIG. 3A

FIG. 3B

FIG. 3C

FIG. 3D

FIG. 4

FIG. 5A

10

1

UV

FIG. 5B

11

10

1

FIG. 5C

11

9

10

1

FIG. 5D

7

10

1

FIG. 6

FIG. 7

FIG. 8

## FIG. 9

## FIG. 10

FIG. 11

FIG. 12

**EP 1 763 081 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10189251 A